# EUROPÄISCHE PATENTSCHRIFT

(11) **EP 0 579 327 B1**
(45) Veröffentlichungstag und Bekanntmachung des Hinweises auf die Patenterteilung: **03.06.1998**
(21) Anmeldenummer: 93202024.1
(22) Anmeldetag: 09.07.1993
(51) Int. Cl.: G11C 29/00

(54) **Integrierter Matrixspeicher mit einer Schaltungsanordnung zum Prüfen der Adressierung**
Integrated matrix memory with an addressing test circuit
Mémoire matricielle intégrée comprenant un circuit de test d'adressage

(30) Priorität: 17.07.1992 DE 4223532
(43) Veröffentlichungstag der Anmeldung: 19.01.1994
(73) Patentinhaber: Philips Patentverwaltung GmbH, 22335 Hamburg (DE); Philips Electronics N.V., 5621 BA Eindhoven (NL)
(72) Erfinder: Meyer, Peter, D-20097 Hamburg (DE)
(74) Vertreter: Poddig, Dieter, Dipl.-Ing.

(56) Entgegenhaltungen:
- EP-A- 0 206 695
- EP-A- 0 509 360
- FR-A- 2 675 601

## Beschreibung

Die Erfindung betrifft einen integrierten Matrixspeicher mit einer Schaltungsanordnung zum Prüfen der Adressierung der Matrix, mit Speicherelementen, die an Kreuzungspunkten von Reihenleitern und Spaltenleitern angeordnet sind, wobei die Adressierung durch eine Mehrbit-Adresse über einen Decoder erfolgt, der wenigstens einen Reihendecoder und einen Spaltendecoder umfaßt, von denen jeder vorgesehen ist, um einen anderen Teil der Adreßbits zu empfangen und zu decodieren und jeweils einen anderen Reihenleiter anzusteuern bzw. wenigstens einen Spaltenleiter über Auswahlschalter auszuwählen und zu wenigstens einem Ausgangsanschluß durchzuschalten.

Bei integrierten Matrix-Halbleiterspeichern sind die Speicherelemente, die an den Kreuzungspunkten von Reihenleitern und Spaltenleitern angeordnet sind, in verschiedener Weise ausgebildet. Bei Speicherelementen, die mit hoher Geschwindigkeit sowohl ausgelesen als auch überschrieben werden können, erfolgt die Prüfung des Speichers nach der Herstellung allgemein in der Weise, daß verschiedene Bitmuster in die Speicherzellen eingeschrieben und wieder ausgelesen werden und die ausgelesenen Bitmuster auf Richtigkeit geprüft werden. Dabei erfolgt die Prüfung der Adressierung solcher Speicher indirekt. Derartige Speicher verlieren jedoch allgemein ihren Inhalt, wenn die Versorgungsspannung abgeschaltet wird. Bei Speichern, die ihren Inhalt auch ohne Versorgungsspannung bewahren, gibt es zum einen sogenannte programmierbare Speicher, deren Inhalt einmal eingeschrieben werden kann und der danach praktisch unveränderbar ist. Bei solchen Speichern wäre es zweckmäßig, vor dem zeitaufwendigen Einschreiben des Inhalts zunächst zu prüfen, ob die getrennte Adressierung der einzelnen Speicherelemente korrekt arbeitet, um defekte Speicher vor dem Beschreiben aussortieren zu können. Es sind jedoch inzwischen auch Speicher bekannt, die als EEPROM bezeichnet werden und deren Inhalt auch elektrisch geändert werden kann, wobei dieser Inhalt nach Abschalten der Spannungsversorgung erhalten bleibt. Das Einschreiben und Löschen solcher Speicher erfordert jedoch einen ganz erheblichen Zeitaufwand, so daß ein Einschreiben verschiedener Bitmuster mit anschließendem Auslesen und Prüfung sehr viel Zeit beansprucht. Auch bei solchen Speichern wäre eine vorhergehende Prüfung, ob die Adressierung der einzelnen Speicherelemente korrekt arbeitet, sehr zweckmäßig.

Aus der EP-480 752 A1 ist eine Schaltungsanordnung zum Prüfen von Halbleiter-Matrixspeichern auf Kurzschlüsse zwischen benachbarten Leitungen bekannt. Zu diesem Zweck wird jedem zweiten Reihenleiter oder jedem zweiten Spaltenleiter ein Signal zugeführt, und es wird geprüft, ob in den dazwischenliegenden Reihenleitern bzw. Spaltenleitern dieses Signal auftritt bzw. ein Strom fließt. Eine derartige Prüfung ist jedoch nur unvollkommen, weil damit keine Unterbrechungen in den Leitungen festgestellt werden können, und auch die Prüfung der Decoder ist damit nicht möglich.

Aufgabe der Erfindung ist es, einen integrierten Matrixspeicher mit einer Schaltungsanordnung der eingangs genannten Art anzugeben, mittels der die Prüfung der Adressierung der Matrix einschließlich der Decoder möglich ist, wobei sowohl Kurzschlüsse nicht nur zwischen benachbarten Leitungen als auch Unterbrechungen von Leitungen feststellbar sind.

Diese Aufgabe wird erfindungsgemäß dadurch gelöst, daß ein Testbus mit einer Anzahl Leiter vorgesehen ist und jeder Leiter mit wenigstens einem Reihenleiter an der vom Reihendecoder abgewandten Seite der Matrix und mit wenigstens einem Spaltenleiter an der von den Auswahlschaltern abgewandten Seite der Matrix koppelbar ist, um jeweils wenigstens eine Anzahl der Reihenleiter mit wenigstens einer Anzahl der Spaltenleiter zu verbinden.

Durch die Verwendung des zusätzlichen Testbusses, der an den von dem Reihendecoder bzw. den Auswahlschaltern abgewandten Seiten der Matrix angeordnet ist, ist nunmehr eine vollständige Überprüfung der Adressierung auf praktisch alle vorkommenden Fehler möglich. Lediglich die Eigenschaften der an den Kreuzungspunkten angebrachten Speicherelemente, d.h. die Schreibbarkeit und Lesbarkeit der einzelnen Speicherelemente für sich, ist damit noch nicht geprüft.

Die Kopplung der Reihenleiter bzw. der Spaltenleiter mit dem Testbus muß während des normalen Betriebes des Matrixspeichers aufgehoben sein, da sonst eine ordnungsgemäße Funktion des Speichers nicht möglich ist. Eine Ausgestaltung der Erfindung ist daher dadurch gekennzeichnet, daß jeder Leiter des Testbusses über erste Testschalter mit wenigstens einem anderen Reihenleiter und/oder über zweite Testschalter mit wenigstens einem anderen Spaltenleiter gekoppelt ist und daß die ersten Testschalter und/oder die zweiten Testschalter durch ein Teststeuersignal wenigstens gruppenweise gemeinsam ansteuerbar sind. Grundsätzlich reicht es aus, entweder nur in Reihe mit den Reihenleitern oder nur in Reihe mit den Spaltenleitern Schalter vorzusehen und die jeweils andere Kopplung als direkte Verbindung auszuführen, jedoch belastet dann die Leitungskapazität des Testbusses die Leiter, mit denen die feste Verbindung besteht, so daß es allgemein zweckmäßig ist, sowohl in Reihe mit den Reihenleitern als auch in Reihe mit den Spaltenleitern Testschalter vorzusehen, damit im Normalbetrieb der Testbus völlig isoliert ist. Diese Testschalter werden selbstverständlich als elektronische Schalter ausgeführt, und zwar allgemein als Feldeffekt-Transistoren, da insbesondere Matrixspeicher auch mit derartigen Transistoren aufgebaut sind.

Bei bei Halbleiterspeichern ist es häufig der Fall, daß nicht nur eine Matrix vorhanden ist, sondern mehrere Matrizen, die miteinander verknüpft gesteuert werden und von denen jede Matrix einem bestimmten Bit eines parallelen Speicherworts zugeordnet ist. Um auch dabei eine weitgehende Prüfung der Adressierung zu ermöglichen, ist eine Ausgestaltung des erfindungsgemäßen Matrixspeichers mit mehreren Matrizen, von denen die Reihenleiter wenigstens einiger der Matrizen, ausgehend von dem Reihendecoder, in Serie geschaltet sind und einer der Spaltenleiter in jeder Matrix gleichzeitig durch den Spaltendecoder auswählbar und zu einem eigenen Ausgangsanschluß für jede Matrix durchschaltbar ist, dadurch gekennzeichnet, daß die Leiter des Testbusses mit den Spaltenleitern aller Matrizen koppelbar sind, wobei die Zuordnung der einzelnen Leiter des Testbusses zu den Spaltenleitern für zumindest einige Matrizen unterschiedlich ist. Durch die Möglichkeit, die Spaltenleiter aller Matrizen mit den Leitern des Testbusses zu koppeln, ist eine vollständige Prüfung aller Spaltenleiter möglich. Durch die zusätzliche Maßnahme, die Zuordnung zwischen Leitern des Testbusses und Spaltenleitern für verschiedene Matrizen unterschiedlich zu gestalten, ist die Erkennung noch weiterer Fehler möglich.

Bei Speichern mit sehr großer Kapazität, die an jeder Adresse ein Mehrbit-Datenwort speichern, wobei jedem Bit eine Matrix zugeordnet ist, ist jede Matrix in mehrere Untermatrizen unterteilt, um die Ansteuerung zu erleichtern. Die gesamte Speicheranordnung besteht dabei also aus einer Matrix von Untermatrizen, wobei die Reihenleiter jeweils eine Zeile von Untermatrizen durchlaufen und die Spaltenleiter jeweils eine Spalte von Untermatrizen. Um auch in diesem Fall eine möglichst vollständige Prüfung der Adressierung zu ermöglichen, ist eine weitere Ausgestaltung des erfindungsgemäßen Matrixspeichers, wobei jede Matrix die gleiche Anzahl unterer Matrizen umfaßt und die Reihenleiter der Untermatrizen parallel angesteuert sind und ein Blockdecoder vorgesehen ist, um in jeder Matrix jeweils nur eine Untermatrix wirksam zu schalten, dadurch gekennzeichnet, daß die Reihenleiter der Untermatrizen über vom Blockdecoder gesteuerte dritte Testschalter mit den Leitern des Testbusses koppelbar sind, wobei die Zuordnung der jeweiligen Reihenleiter zu den Leitern des Testbusses zumindest bei einigen Untermatrizen unterschiedlich ist. Hierbei ist die Verwendung von Testschaltern sowohl in Reihe mit den Reihenleitern als auch in Reihe mit den Spaltenleitern notwendig. Da diese Testschalter jedoch alle parallel angesteuert werden, während es bei dieser Anordnung erforderlich ist, die Reihenleiter der einzelnen Zeilen von Untermatrizen getrennt zu prüfen, sind die dritten Testschalter erforderlich. Da diese dritten Testschalter nur für den Test erforderlich sind, sind sie ebenfalls zweckmäßig an der dem Reihendecoder abgewandten Seite der jeweiligen Zeile von Untermatrizen angeordnet. Eine weitere Ausgestaltung dieses erfindungsgemäßen Speichers ist daher dadurch gekennzeichnet, daß die dritten Testschalter in Reihe mit den ersten Testschaltern angeordnet sind. Dies ermöglicht auch einen einfachen Aufbau.

Bei umfangreichen Matrizen ist es zur Verkürzung von Leitungslängen zweckmäßig, die Matrizen aufzuteilen und die Reihendecoder zwischen den Matrizen anzuordnen, so daß die Reihenleiter vom Decoder bis zur jeweils letzten Matrix entsprechend kürzer sind. Um auch in diesem Falle eine wirksame Prüfung der Adressierung zu ermöglichen, ist eine weitere Ausgestaltung des erfindungsgemäßen Matrixspeichers, wobei die Matrizen auf zwei gleich große Gruppen verteilt sind und der Reihendecoder zwischen den beiden Gruppen angeordnet ist und die Reihenleiter für beide Gruppen parallel ansteuert, dadurch gekennzeichnet, daß an den vom Reihendecoder abgewandten Seiten beider Gruppen von Matrizen je ein Testbus vorgesehen ist, wobei jeder Testbus wenigstens mit den Spaltenleitern eines Teils der Matrizen koppelbar ist. Die gesamte Matrixanordnung besteht somit einschließlich der Testbusse aus zwei Teilen, die zueinander praktisch spiegelbildlich sind. Dies erspart auch Entwurfsarbeit bei der praktisch Ausführung einer solchen Matrixanordnung.

Ausführungsbeispiele der Erfindung werden nachstehend anhand der Zeichnung näher erläutert. Es zeigen:
- Fig. 1a: die erfindungsgemäße Schaltungsanordnung für eine einfache Matrix,
- Fig. 1b und 1c: Kopplungsmöglichkeiten für die Fälle, daß die Anzahl der Reihenleiter bzw. der Leiter des Testbusses unterschiedlich zur Anzahl der Spaltenleiter ist,
- Fig. 2a: die erfindungsgemäße Schaltungsanordnung für eine Kette von Matrizen,
- Fig. 2b: Möglichkeiten für eine unterschiedliche Kopplung der Spaltenleiter der einzelnen Matrizen mit den Leitern des Testbusses,
- Fig. 3: eine erfindungsgemäße Schaltungsanordnung mit zwei Testbussen für eine in zwei Gruppen von Matrizen aufgeteilte Matrixanordnung.

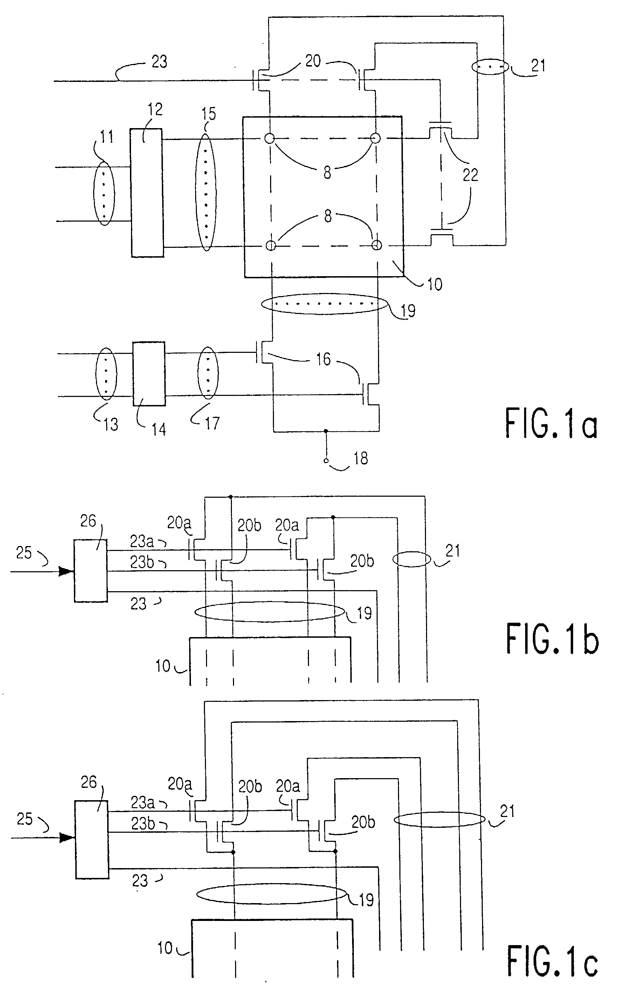

Die Fig. 1a zeigt schematisch eine Matrix 10, durch die eine Anzahl Reihenleiter 15 läuft, von denen hier der Übersichtlichkeit halber nur der erste und der letzte Reihenleiter dargestellt sind. Senkrecht zu diesen Reihenleitern 15 läuft durch die Matrix 10 eine Anzahl Spaltenleiter 19, von denen hier ebenfalls der Übersichtlichkeit halber nur der erste und der letzte Spaltenleiter dargestellt sind. An den Kreuzungspunkten der Reihenleiter 15 und der Spaltenleiter 19 sind Elemente 8 angeordnet. Dies mögen in dem hier beschriebenen Beispiel EPROM-Speicherzellen sein, deren Aufbau grundsätzlich bekannt ist und für die Erfindung nicht von Bedeutung ist, so daß diese Elemente hier nicht näher beschrieben werden. Ferner sind noch Versorgungsspannungen zum Betrieb der Elemente erforderlich, die hier ebenfalls nicht näher dargestellt sind.

Die Reihenleiter 15 werden von einem Reihendecoder 12 angesteuert, der über die Eingangsleitungen 11 einen Teil der Bits einer Mehrbit-Adresse empfängt und diese so decodiert, daß jeweils nur einer der Reihenleiter 15 angesteuert wird.

Die Spaltenleiter 19 führen über Schalter, die hier als Feldeffekt-Transistoren 16 dargestellt sind, auf einen gemeinsamen Ausgang 18. Die Transistoren 16 werden über Auswahlleitungen 17 angesteuert, die mit Ausgängen eines Spaltendecoders 14 verbunden sind. Dieser Spaltendecoder 14 empfängt über die Eingangsleitungen 13 die restlichen Bits der Mehrbit-Adresse und decodiert diese derart, daß jeweils nur eine Auswahlleitung 17 angesteuert wird. Auf diese Weise wird der gespeicherte Inhalt einer Speicherzelle 8, die am Kreuzungspunkt eines Reihenleiters 15 und eines Spaltenleiters 19 angeordnet ist, am Ausgang 18 abgegeben. Voraussetzung ist dabei, daß tatsächlich nur ein einziger Reihenleiter 15 vom Reihendecoder 12 angesteuert wird und daß dieser Reihenleiter 15 ohne Unterbrechung bis zu den letzten Elementen 8 der Matrix 10 verläuft und auch keinen Kurzschluß mit einem anderen Reihenleiter oder einem sonstigen Leiter, beispielsweise einem Spaltenleiter, aufweist. Entsprechend muß auch jeder Spaltenleiter 19 von dem obersten Element 8 bis zum unteren Ausgang der Matrix 20 verlaufen und darf ebenfalls keine Unterbrechung und auch keinen Kurzschluß mit einem anderen Spaltenleiter oder einem sonstigen Leiter aufweisen, und es darf auch nur einer der Auswahl-Transistoren 16 leitend geschaltet werden, d.h. der Spaltendecoder 14 darf jeweils nur eine der Auswahlleitungen 17 ansteuern.

Um dies zu prüfen, können verschiedene Bitmuster in die Matrix 10 eingeschrieben und wieder daraus ausgelesen werden und auf Übereinstimmung mit dem eingeschriebenen Bitmuster geprüft werden. Da EEPROM-Speicherzellen zum Einschreiben eine merkliche Zeitdauer benötigen, würde insbesondere bei einer großen Matrix 10 mit vielen Reihenleitern und Spaltenleitern eine erhebliche Zeit für die Prüfung benötigt. Daher ist die in Fig. 1a dargestellte Anordnung mit der Matrix 10 sowie den Decodern 12 und 14 mit einer zusätzlichen Prüfschaltung versehen, die einen Testbus 21 mit einer Anzahl Leitern umfaßt. Die Leiter des Testbusses 21 sind über Schalter, die hier wieder als Feldeffekt-Transistoren 22 und 20 dargestellt sind, mit den Reihenleitern 15 an der vom Reihendecoder 12 abgewandten Seite der Matrix 10 und mit den Spaltenleitern 19 an der von den Auswahltransistoren 16 abgewandten Seite der Matrix 10 verbunden.

Zur Prüfung der Adressierung werden nun durch ein entsprechendes Signal auf der Testleitung 23 alle Transistoren 20 und 22 leitend geschaltet, und dann werden nacheinander alle möglichen Adreßbitkombinationen über die Leitungen 11 und 13 dem Reihendecoder 12 und dem Spaltendecoder 14 zugeführt, wobei für jede Bitkombination der Eingänge 11 alle Bitkombinationen der Eingänge 13 erzeugt werden, oder umgekehrt für jede Bitkombination an den Eingängen 13 alle möglichen Bitkombinationen an den Eingängen 11. Für jede Bitkombination an den Eingängen 11 bzw. 13 darf nur für eine bestimmte Bitkombination an den Eingängen 13 bzw. 11 am Ausgang 18 ein Signal erscheinen. Wenn ein Kurzschluß zwischen zwei Reihenleitern 15 bestehen sollte oder der Reihendecoder 12 aufgrund eines Fehlers mehr als einen Reihenleiter gleichzeitig ansteuert, wird bei einer Bitkombination an den Eingängen 11 bei mehreren Bitkombinationen an den Eingängen 13 ein Signal am Ausgang 18 erzeugt. Entsprechendes gilt, wenn Kurzschlüsse zwischen Spaltenleitern 19 oder zwischen Auswahlleitungen 17 vorhanden sind oder wenn der Spaltendecoder 14 durch einen Fehler mehr als eine Auswahlleitung 17 gleichzeitig ansteuert. Wenn dagegen ein Reihenleiter 15 oder ein Spaltenleiter 19 oder eine Auswahlleitung 17 eine Unterbrechung aufweisen sollte oder der Reihendecoder 12 oder der Spaltendecoder 14 bei wenigstens einer Bitkombination kein Ausgangssignal erzeugen sollte oder wenn einer der Auswahlschalter 16 defekt ist, wird bei den entsprechenden Bitkombinationen an den Eingängen 11 und 13 am Ausgang 18 kein Signal auftreten. Somit kann aus den überzähligen oder fehlenden Signalen am Ausgang 18 ein Fehler an irgendeinem der Teile, die zur Adressierung gehören, erkannt werden.

Bei der Anordnung nach Fig. 1a ist angenommen, daß die Anzahl der Reihenleiter 15 gleich der Anzahl der Spaltenleiter 19 ist. Diese Annahme ist jedoch nicht bei allen vorkommenden Matrizen gegeben. Wenn einerseits die Anzahl der Spaltenleiter 19 beispielsweise doppelt so groß ist wie die Anzahl der Reihenleiter 15, die gleich der Anzahl der Leiter im Testbus 21 ist, kann jeder Leiter des Testbusses 21 mit zwei Spaltenleitern verbunden werden, die zweckmäßig weit voneinander entfernt liegen, um Kurzschlüsse zwischen benachbarten Spaltenleitern noch erkennen zu können. Dann müssen für jede Bitkombination an den Eingängen 11 und allen Bitkombinationen an den Eingängen 13 zwei Signale am Ausgang 18 auftreten.

Eine andere Möglichkeit ist in Fig. 1b dargestellt, wo jeder Leiter des Testbusses 21 über zwei getrennte Transistoren 20a bzw. 20b mit einem anderen Spaltenleiter verbunden ist. Die Transistoren 20a und 20b werden über Testleitungen 23a und 23b von einer Testanordnung 26, die über einen Eingang 25 angesteuert wird, abwechselnd betätigt, während die Leitung 23 jedesmal die Transistoren 22 ansteuert. In diesem Falle tritt nur bei einer eindeutigen Kombination von Adreßbits an den Eingängen 11 und 13 sowie Testsignalen auf den Leitungen 23a und 23b ein Signal am Ausgang 18 auf.

Wenn andererseits die Anzahl der Reihenleiter 15 größer ist als die Anzahl der Spaltenleiter 19, können zwei oder mehr Reihenleiter mit demselben Leiter des Testbusses 21 verbunden sein, der dann eine Anzahl Leiter gleich der Anzahl Spaltenleiter 19 aufweist. Eine andere Möglichkeit ist in Fig. 1c dargestellt. Hier ist jeder Spaltenleiter 19 über zwei Transistoren 20a bzw. 20b mit einem anderen Leiter des Testbusses 21 verbunden, und die Transistoren 20a und 20b werden wieder über getrennte Testleitungen 23a und 23b von einer Testanordnung 26 abwechselnd angesteuert, während die Leitung 23 jedesmal ein Signal erhält. Auch in diesem Falle tritt am Ausgang 18 jeweils nur bei einer Kombination von Adressbits an den Eingängen 11 und 13 und nur bei einem der Testsignale auf den Leitungen 23a und 23b ein Signal auf.

Es ist also leicht zu erkennen, daß auch für die Fälle, in denen die Anzahl der Reihenleiter nicht mit der Anzahl der Spaltenleiter übereinstimmt, eine praktisch vollständige Prüfung der Adressierung mit Hilfe eines Testbusses möglich ist.

Bei manchen Matrixanordnungen sind mehrere getrennte Matrizen vorhanden, die jedoch parallel angesteuert werden. Dies ist beispielsweise der Fall bei Halbleiterspeichern, die an jeder Adresse ein Datenwort aus mehreren Bits speichern, wobei jedem Bit dann eine eigene Matrix zugeordnet ist.

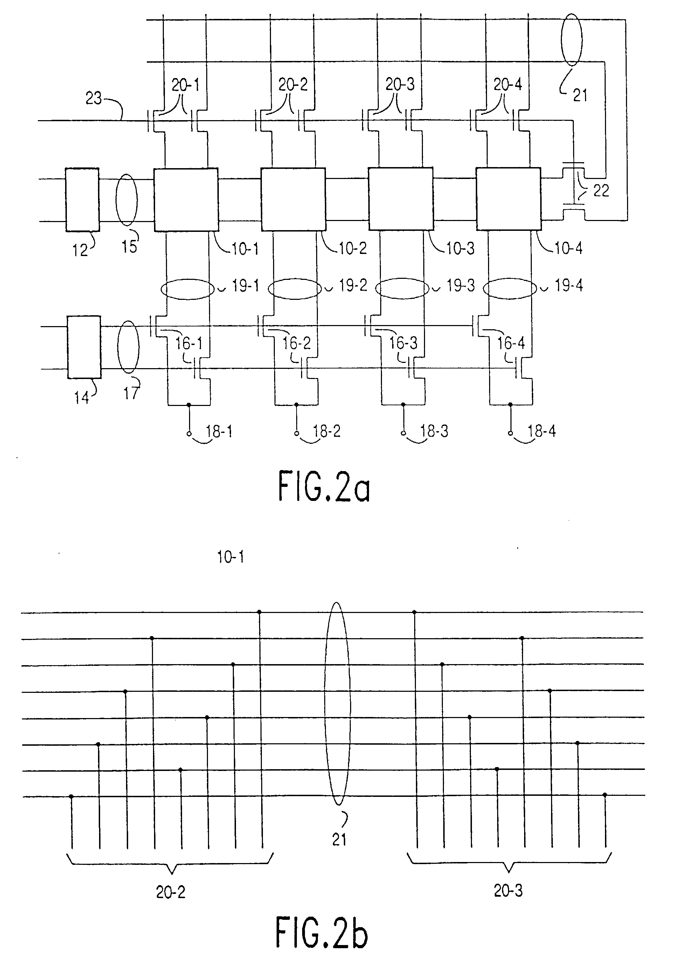

Der grundsätzliche Aufbau einer solchen Speicheranordnung ist in Fig. 2a angedeutet. Darin sind vier Matrizen 10-1, 10-2, 10-3 und 10-4 angegeben, die untereinander gleich aufgebaut sind und die von denselben Reihenleitern 15 durchlaufen werden, die wieder vom Reihendecoder 12 angesteuert werden. Die Spaltenleiter 19-1, 19-2, 19-3 und 19-4 der einzelnen Matrizen führen über getrennte Auswahltransistoren 16-1, 16-2, 16-3 und 16-4, die über gemeinsame Auswahlleitungen 17 vom Spaltendecoder 14 angesteuert werden, auf getrennte Ausgänge 18-1, 18-2, 18-3 und 18-4 für jede Matrix. Beim Zuführen einer Adresse zum Reihendecoder 12 und Spaltendecoder 14 wird also in jeder Matrix 10-1 bis 10-4 das gleiche Element ausgewählt, so daß der Inhalt der gleichen Speicherelemente in jeder Matrix parallel an den Ausgängen 18-1 bis 18-4 erscheint.

Bei der Anordnung nach Fig. 2a sind die Reihenleiter 15 an der vom Reihendecoder 12 abgewandten Seite der Matrizen, d.h. am Ausgang der Matrix 10-4, über Transistoren 22 mit den Leitern eines Testbusses 21 verbunden. Die Leiter des Testbusses 21 führen über die Transistoren 20-1, 20-2, 20-3 und 20-4 zu den Spaltenleitern 19-1 bis 19-4 aller Matrizen. Die Verbindung der Leiter des Testbusses 21 mit den Leitungen, die zu den Transistoren 20-1 bis 20-4 führen, ist in Fig. 2a nicht im einzelnen angegeben und wird zunächst für jede Matrix wie in Fig. 1a angegeben angenommen. Wenn nun durch ein entsprechendes Signal auf der Leitung 23 alle Transistoren 20-1 bis 20-4 und 22 leitend sind, erscheint für jede dem Reihendecoder 12 zugeführte Adreßbitkombination nur bei einer bestimmten, dem Spaltendecoder 14 zugeführten Adreßbitkombination an allen Ausgängen 18-1 bis 18-4 gleichzeitig ein Signal, sofern die Adressierung fehlerfrei ist. Bei einem Fehler im Reihendecoder 12 oder in den Reihenleitern 15 erscheint an allen Ausgängen 18-1 bis 18-4 dasselbe abweichende Bitmuster. Wenn jedoch in den Spaltenleitern einer der Matrizen, beispielsweise in den Spaltenleitern 19-2 der Matrix 10-2, ein Fehler vorhanden ist, erscheint am Ausgang 18-2 ein anderes Bitmuster als an den übrigen Ausgängen. Auf diese Weise ist nicht nur ein eventueller Fehler zu erkennen, sondern es erscheinen gleichzeitig Hinweise auf einen möglichen Fehlerort, was für Maßnahmen bei der Herstellung derartiger Matrixanordnungen vorteilhaft ausgenutzt werden kann.

Um noch weitergehende Hinweise auf einen eventuellen Fehlerort zu erhalten und um zu erschweren, daß bestimmte Fehler nicht erkannt werden können, ist es zweckmäßig, die Verbindung der Leiter des Testbusses 21 mit den zu den Transistoren 20-1 bis 20-4 führenden Leitungen für die einzelnen Matrizen unterschiedlich vorzunehmen. Ein Beispiel hierfür ist in Fig. 2b angedeutet. Dabei ist angenommen, daß der Testbus 21 acht Leiter umfaßt, und daß jede Matrix auch acht Spaltenleiter aufweist. Diejenigen Leitungen, die beispielsweise zu den Transistoren 20-2 in Fig. 2a führen, sind in anderer Folge mit den Leitern des Testbusses 21 verbunden als die Leitungen, die zu den Transistoren 20-3 führen, und zwar ist die Kombination der Verbindungen hier spiegelbildlich angegeben. Andere Kombinationen von Verbindungen sind jedoch ebenfalls geeignet. Falls die Anzahl der Spaltenleiter jedoch größer ist als die Anzahl der Leiter im Testbus 21, können mehrere Spaltenleiter, die zweckmäßig jedoch nicht unmittelbar benachbart sein sollten, mit demselben Leiter des Testbusses 21 verbunden werden, oder es kann auch die Anordnung nach Fig. 1b verwendet werden.

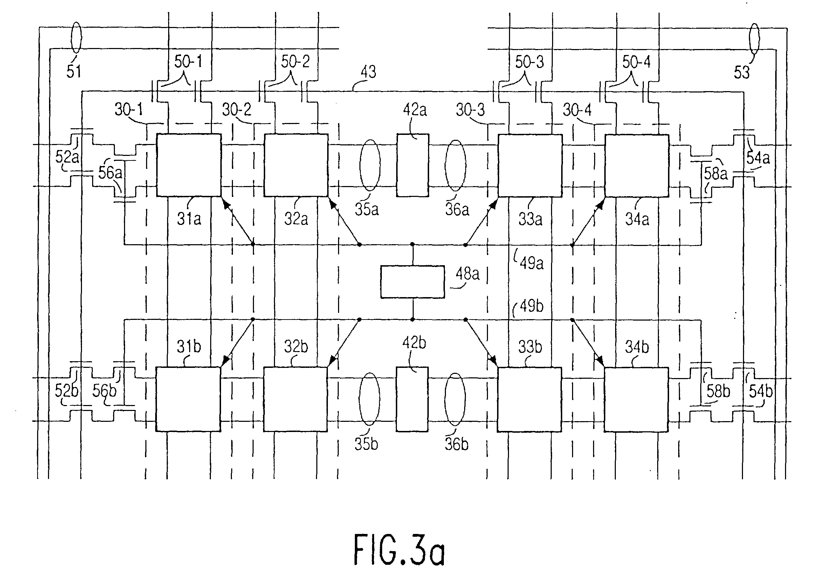

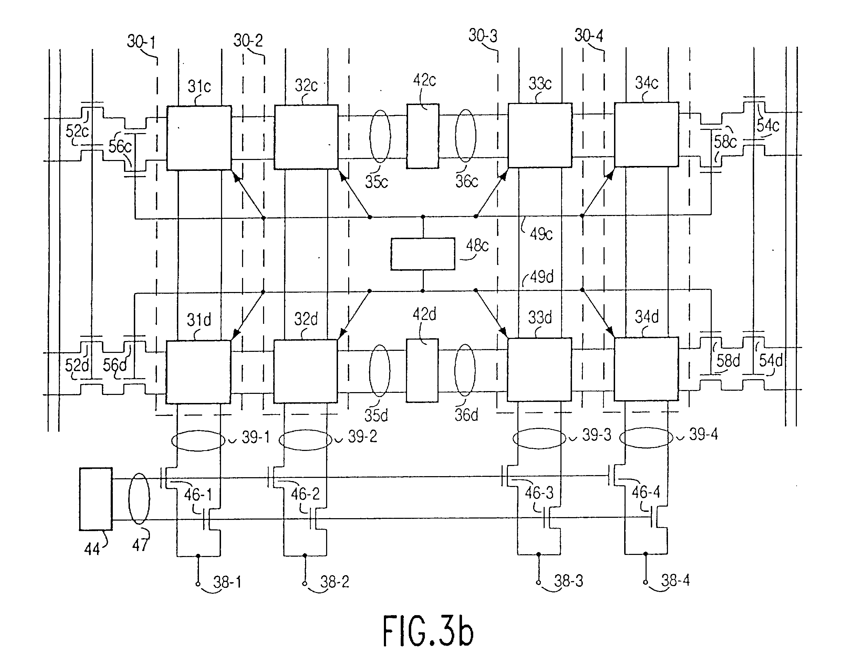

Wenn die einzelnen Matrizen 10-1 bis 10-4 sehr groß werden, d.h. eine große Kapazität aufweisen, ist es aus Gründen der Arbeitsgeschwindigkeit günstig, jede Matrix in eine gleiche Anzahl Untermatrizen zu unterteilen. Eine derartige Anordnung ist in Fig. 3 dargestellt. Es sind wieder vier Matrizen 30-1, 30-2, 30-3 und 30-4 vorhanden, von denen jede vier Untermatrizen aufweist. Insbesondere weist die Matrix 30-1 die Untermatrizen 31a, 31b, 31c und 31d auf. Entsprechend weist die Matrix 30-2 vier Untermatrizen 32a bis 32d auf, die Matrix 30-3 vier Untermatrizen 33a bis 33d und die Matrix 30-4 vier Untermatrizen 34a bis 34d. Die Untermatrizen bilden also selbst wieder eine Matrix, wobei eine Spalte von Untermatrizen zu jeweils einer Matrix gehört und eine Zeile von Untermatrizen durch die Untermatrizen gleicher Ordnung in allen Matrizen gebildet wird.

In jeder Matrix durchlaufen die Spaltenleiter die Untermatrizen nacheinander, beispielsweise in der Matrix 30-1 durchlaufen die Spaltenleiter 39-1 nacheinander die Untermatrizen 31d, 31c, 31b und 31a. Die Reihenleiter durchlaufen hier jedoch nicht alle Untermatrizen einer Zeile von Untermatrizen nacheinander, sondern die Matrizen sind in zwei Gruppen 30-1 und 30-2 sowie 30-3 und 30-4 unterteilt, und zwischen diesen beiden Gruppen ist der Reihendecoder angeordnet, der hier aus vier Reihendecodern 42a, 42b, 42c und 42d besteht. Diese sind untereinander gleich aufgebaut und werden parallel mit denselben Adreßbits angesteuert, was hier der Übersichtlichkeit halber nicht näher dargestellt ist. Der Reihendecoder 42a steuert nun die Reihenleiter 35a an, die die Untermatrizen 32a und 31a nacheinander durchlaufen, und parallel hierzu steuert der Reihendecoder 42a auch die Reihenleiter 36a an, die die Untermatrizen 33a und 34a nacheinander durchlaufen. Gleichartige Reihenleiter 35a und 36a können auch in dem Reihendecoder 42a direkt miteinander und mit dem Ausgang eines entsprechenden Ausgangsverstärkers des Reihendecoders 42a verbunden sein. In entsprechender Weise steuern die Reihendecoder 42b die Reihenleiter 35b und 36b, die die Untermatrizen 32b und 31b bzw. 33b und 34b nacheinander durchlaufen, und entsprechendes gilt für die anderen Reihendecoder und Reihenleiter.

Zusätzlich ist in der Anordnung nach Fig. 3 noch ein Blockdecoder vorgesehen, der hier aus zwei einzelnen Blockdecodern 48a und 48c besteht, die die Blockauswahlleitungen 49a, 49b, 49c und 49d derart ansteuern, daß jeweils nur eine dieser vier Leitungen angesteuert ist. Jede der Auswahlleitungen 49a bis 49d steuert die Untermatrizen gleicher Ordnung der vier Matrizen aktiv, beispielsweise aktiviert ein Signal auf der Auswahlleitung 49a die Untermatrizen 31a, 32a, 33a und 34a. Wenn die Reihendecoder 42a bis 42d eine bestimmte Adresse erhalten, steuern diese alle denselben Reihenleiter 35a bis 35d und 36a bis 36d an, so daß in allen Untermatrizen dieselbe Reihe von Elementen adressiert wird, jedoch wird die Adressierung des Reihenleiters nur in derjenigen Zeile von Untermatrizen wirksam, die durch die Blockdecoder 48a bzw. 48c ausgewählt ist. Nur die Elemente dieser Reihenleiter werden mit den entsprechenden Spaltenleitern 39-1 bis 39-4 verknüpft. Von diesen Spaltenleitern wird im fehlerfreien Fall nur einer durch die Auswahltransistoren 46-1, 46-2, 46-3 und 46-4, die über die Auswahlleitungen 47 vom Spaltendecoder 44 angesteuert werden, ausgewählt und zum Ausgang 38-1, 38-2, 38-3 oder 38-4 durchgeschaltet.

Die Adressierung der einzelnen Elemente in den Matrizen bzw. Untermatrizen erfolgt somit auf drei Wegen, nämlich über die Reihendecoder 42a, 42b, 42c und 42d und die daran angeschlossenen Reihenleiter, durch die Blockdecoder 48a und 48c sowie die daran angeschlossenen Auswahlleitungen und durch den Spaltendecoder 44. In die Prüfung der richtigen Adressierung müssen also alle drei Decoder mit einbezogen werden. Ferner muß die Aufteilung der Matrizen 30-1 bis 30-4 in zwei Gruppen berücksichtigt werden. Dies geschieht bei der Anordnung nach Fig. 3 zum einen dadurch, daß zwei Testbusse 51 und 53 vorgesehen sind. Von diesen ist der Testbus 51 über die Reihenschaltung der Transistoren 52a und 56a mit den Reihenleitern 35 verbunden, ferner über die Reihenschaltung der Transistoren 52b und 56b mit den Reihenleitern 35b, über die Reihenschaltung der Transistoren 52c und 56c mit den Reihenleitern 35c und über die Reihenschaltung der Transistoren 52d und 56d mit den Reihenleitern 35d. Davon werden die Transistoren 52a bis 52d gemeinsam über die Testleitung 43 angesteuert. Die Transistoren 56a werden dagegen über die Blockauswahlleitung 49a vom Blockdecoder 48a gesteuert. Entsprechend werden die Transistoren 56b bis 56d über eine der Blockauswahlleitungen 49b bis 49d gesteuert. Dadurch sind beim Prüfen, abhängig von den den Blockdecodern 48a und 48c zugeführten Adreßbits, entweder nur die Reihenleiter 35a oder 35b oder 35c oder 35d mit dem Testbus 51 verbunden.

Die Verbindung der Ausgänge der Transistoren 52a bis 52d mit den Leitern des Testbusses 51 kann nun in der Weise erfolgen, wie dies in den Figuren 1a und 2a für die Reihenleiter 15 mit dem Testbus 21 angegeben ist, jedoch ist es auch günstig, diese Verbindungen für die einzelnen Zeilen von Untermatrizen unterschiedlich zu wählen, wie dies beispielsweise grundsätzlich in Fig. 2b angedeutet ist.

Die Verbindung des Testbusses 51 mit den Spaltenleitern erfolgt über die Transistoren 50-1 und 50-2 hier nur mit den Spaltenleitern 39-1 und 39-2 der Matrizen 30-1 und 30-2. Auch diese Verbindungen können wieder unterschiedlich gestaltet werden, wie in Fig. 2b angedeutet ist, um eine möglichst gute Fehlererkennung und möglicherweise eine Erkennung der Fehlerart zu erleichtern.

Für die Matrizen 30-3 und 30-4 ist der Testbus 53 vorgesehen, der über die Reihenschaltung der Transistoren 54a und 58a mit den Reihenleitern 36a, über die Reihenschaltung der Transistoren 54b und 58b mit den Reihenleitern 36b, über die Transistoren 54c und 58c mit den Reihenleitern 36c und über die Reihenschaltung der Transistoren 54d und 58d mit den Reihenleitern 36d verbunden ist. Auch hier werden die Transistoren 54a bis 54d gemeinsam durch ein Signal über die Testleitung 43 angesteuert, während die Transistoren 58a bis 58d getrennt über jeweils eine der Blockauswahlleitungen 49a bis 49d von einem Blockdecoder 48a bzw. 48c angesteuert werden. Dieser Aufbau ist also symmetrisch zu dem Aufbau und dem Anschluß des Testbusses 51. Der Testbus 51 ist auch nur über die Transistoren 50-3 und 50-4 mit den Spaltenleitern 39-3 und 39-4 verbunden. Die Verbindung der Leiter des Testbusses 53 mit den Transistoren ist zweckmäßig bei benachbarten Spalten und Zeilen von Untermatrizen ebenso unterschiedlich wie beim Testbus 51 und können mit dessen Verbindungen übereinstimmen.

Grundsätzlich können die Testbusse 51 und 53 sich über die Spaltenleitungen aller Matrizen erstrecken, insbesondere dann, wenn die Anzahl der Spaltenleiter größer ist als die Anzahl Leitungen in den beiden Testbussen. Dies ergibt jedoch einen erhöhten Verdrahtungsaufwand und erhöht praktisch nicht die Möglichkeit einer Fehlererkennung.

## Patentansprüche

1. Integrierter Matrixspeicher mit einer Schaltungsanordnung zum Prüfen der Adressierung der Matrix (10; 10-1 bis 10-4; 30-1 bis 30-4) mit Speicherelementen, die an Kreuzungspunkten von Reihenleitern (15; 35a bis 35d, 36a bis 36c) und Spaltenleitern (19; 19-1 bis 19-4; 39-1 bis 39-4) angeordnet sind, wobei die Adressierung durch eine Mehrbit-Adresse über einen Decoder erfolgt, der wenigstens einen Reihendecoder (12; 42a bis 42d) und einen Spaltendecoder (14; 44) umfaßt, von denen jeder vorgesehen ist, um einen anderen Teil der Adreßbits zu empfangen und zu decodieren und jeweils einen anderen Reihenleiter anzusteuern bzw. wenigstens einen Spaltenleiter über Auswahlschalter (16; 16-1 bis 16-4; 46-1 bis 46-4) auszuwählen und zu wenigstens einen Ausgangsanschluß (18; 18-1 bis 18-4; 38-1 bis 38-4) durchzuschalten,
dadurch gekennzeichnet, daß ein Testbus (21; 51, 53) mit einer Anzahl Leiter vorgesehen ist und jeder Leiter mit wenigstens einem Reihenleiter (15; 35a bis 35d, 36a bis 36d) an der vom Reihendecoder (12; 42a bis 42d) abgewandten Seite der Matrix (10; 10-1 bis 10-4; 30-1 bis 30-4) und mit wenigstens einem Spaltenleiter (19; 19-1 bis 19-4: 39-1 bis 39-4) an der von den Auswahlschaltern (16; 16-1 bis 16-4; 46-1 bis 46-4) abgewandten Seite der Matrix koppelbar ist, um jeweils wenigstens eine Anzahl der Reihenleiter mit wenigstens einer Anzahl der Spaltenleiter zu verbinden.

2. Matrixspeicher nach Anspruch 1,
dadurch gekennzeichnet, daß jeder Leiter des Testbusses (21; 51, 53) über erste Testschalter (22; 52a bis 52d, 54a bis 54d) mit wenigstens einem anderen Reihenleiter (15; 35a bis 35d, 36a bis 36d) und/oder über zweite Testschalter (20; 20-1 bis 20-4; 50-1 bis 50-4) mit wenigstens einem anderen Spaltenleiter (19; 19-1 bis 19-4; 39-1 bis 39-4) gekoppelt ist und daß die ersten Testschalter und/oder die zweiten Testschalter durch ein Teststeuersignal wenigstens gruppenweise gemeinsam ansteuerbar sind.

3. Matrixspeicher nach Anspruch 2 mit mehreren Matrizen (10-1 bis 10-4; 30-1 bis 30-4), von denen die Reihenleiter (15; 35a bis 35d, 36a bis 36d) wenigstens einiger der Matrizen (10-1 bis 10-4; 30-1 bis 30-4), ausgehend von dem Reihendecoder (12; 42a bis 42d), in Serie geschaltet sind und einer der Spaltenleiter (19-1 bis 19-4, 39-1 bis 39-4) in jeder Matrix gleichzeitig durch den Spaltendecoder (14; 44) auswählbar und zu einem eigenen Ausgangsanschluß (18-1 bis 18-4; 38-1 bis 38-4) für jede Matrix durchschaltbar ist,
dadurch gekennzeichnet, daß die Leiter des Testbusses (21; 51, 53) mit den Spaltenleitern (19-1 bis 19-4, 39-1 bis 39-4) aller Matrizen (10-1 bis 10-4, 30-1 bis 30-4) koppelbar sind, wobei die Zuordnung der einzelnen Leiter des Testbusses zu den Spaltenleitern für zumindest einige Matrizen unterschiedlich ist.

4. Matrixspeicher nach Anspruch 3, wobei jede Matrix (30-1 bis 30-4) die gleiche Anzahl Untermatrizen (31a bis 31d, ... 34a bis 34b) umfaßt und die Reihenleiter (35a, 36a bis 35d, 36d) der Untermatrizen parallel angesteuert sind und ein Blockdecoder (48a, 48c) vorgesehen ist, um in jeder Matrix jeweils nur eine Untermatrix wirksam zu schalten,
dadurch gekennzeichnet, daß die Reihenleiter (35a, 36a bis 35d, 36d) der Untermatrizen (31a bis 34a, ... 31d bis 34d) über vom Blockdecoder (48a, 48c) gesteuerte dritte Testschalter (56a bis 56d, 58a bis 58d) mit den Leitern des Testbusses (51, 53) koppelbar sind, wobei die Zuordnung der jeweiligen Reihenleiter zu den Leitern des Testbusses zumindest bei einigen Untermatrizen unterschiedlich ist.

5. Matrixspeicher nach Anspruch 4,
dadurch gekennzeichnet, daß die dritten Testschalter (56a bis 56d, 58a bis 58d) in Reihe mit den ersten Testschaltern (52a bis 52d, 54a bis 54d) angeordnet sind.

6. Matrixspeicher nach Anspruch 3, 4 oder 5, wobei die Matrizen (10-1 bis 10-4; 30-1 bis 30-4) auf zwei gleich große Gruppen verteilt sind und der Reihendecoder (42a bis 42d) zwischen den beiden Gruppen angeordnet ist und die Reihenleiter (35a bis 35d und 36a bis 36d) für beide Gruppen parallel ansteuert,
dadurch gekennzeichnet, daß an den vom Reihendecoder (42a bis 42d) abgewandten Seiten beider Gruppen von Matrizen (30-1, 30-2 und 30-3, 30-4) je ein Testbus (51, 53) vorgesehen ist, wobei jeder Testbus wenigstens mit den Spaltenleitern (39-1 bis 39-4) eines Teils der Matrizen (30-1, 30-2 und 30-3, 30-4) koppelbar ist.

## Claims

1. An integrated matrix memory, comprising a circuit arrangement for testing the addressing of the matrix (10; 10-1 to 10-4; 30-1 to 30-4) and storage elements which are arranged at intersections of row conductors (15; 35a to 35d, 36a to 36c) and column conductors (19; 19-1 to 19-4; 39-1 to 39-4), the addressing taking place by way of a multibit address, via a decoder which comprises at least one row decoder (12; 42a to 42d) and one column decoder (14; 44), each of which is arranged to receive and decode a different part of the address bits and to drive each time a different row conductor or to select at least one column conductor, via selection switches (16; 16-1 to 16-4; 46-1 to 46-4), for connection to at least one output terminal (18; 18-1 to 18-4; 38-1 to 38-4),
characterized in that there is provided a test bus (21; 51, 53) with a number of conductors and that at the side of the matrix (10; 10-1 to 10-4; 30-1 to 30-4) which is remote from the row decoder (12; 42a to 42d) each conductor can be coupled to at least one row conductor (15; 35a to 35d, 36a to 36d) and to at least one column conductor (19; 19-1 to 19-4; 39-1 to 39-4) at the side of the matrix which is remote from the selection switches (16; 16-1 to 16-4; 46-1 to 46-4) in order to connect each time at least a number of the row conductors to at least a number of the column conductors.

2. A matrix memory as claimed in Claim 1,
characterized in that each conductor of the test bus (21; 51, 53) is coupled to at least one further row conductor (15; 35a to 35d, 36a to 36d) via first test switches (22; 52a to 52d, 54a to 54d) and/or to at least one further column conductor (19; 19-1 to 19-4; 39-1 to 39-4) via second test switches (20; 20-1 to 20-4; 50-1 to 50-4), the first test switches and/or the second test switches being dryable at least group-wise together by a test control signal.

3. A matrix memory as claimed in Claim 2, comprising a plurality of matrices (10-1 to 10-4; 30-1 to 30-4) in which the row conductors (15; 35a to 35d, 36a to 36d) of at least some of the matrices (10-1 to 10-4; 30-1 to 30-4), starting from the row decoder (12; 42a to 42d), are connected in series and one of the column conductors (19-1 to 19-4, 39-1 to 39-4) in each matrix can be simultaneously selected by the column decoder (14; 44) and connected to an own output terminal (18-1 to 18-4; 38-1 to 38-4) for each matrix,
characterized in that the conductors of the test bus (21; 51, 53) can be coupled to the column conductors (19-1 to 19-4, 39-1 to 39-4) of all matrices (10-1 to 10-4, 30-1 to 30-4), the assignment of the individual conductors of the test bus to the column conductors being different for at least some matrices.

4. A matrix memory as claimed in Claim 3, in which each matrix (30-1 to 30-4) comprises the same number of sub-matrices (31a to 31d, ..., 34a to 34d), the row conductors (35a, 36a to 35d, 36d) of the sub-matrices are controlled in parallel and a block decoder (48a, 48c) is provided so as to activate each time only one sub-matrix in each matrix,
characterized in that the row conductors (35a, 36a to 35d, 36d) of the sub-matrices (31a to 34a ..., 31d to 34d) can be coupled to the conductors of the test bus (51, 53) via third test switches (56a to 56d, 58a to 58d) which are controlled by the block decoder (48a, 48c), the assignment of the relevant row conductor to the conductors of the test bus being different for at least some sub-matrices.

5. A matrix memory as claimed in Claim 4,
characterized in that the third test switches (56a to 56d, 58a to 58d) are connected in series with the first test switches (52a to 52d, 54a to 54d).

6. A matrix memory as claimed in Claim 3, 4 or 5, in which the matrices (10-1 to 10-4; 30-1 to 30-4) are distributed between two equally large groups and the row decoder (42a to 42d) is arranged between the two groups and controls the row conductors (35a to 35d and 36a to 36d) for both groups in parallel,
characterized in that at the sides of both groups of matrices (30-1, 30-2 and 30-3, 30-4) which are remote from the row decoder (42a to 42d) there is provided a respective test bus (51, 53), it being possible to couple each test bus at least to the column conductors (39-1 to 39-4) of a part of the matrices (30-1, 30-2 and 30-3, 30-4).

## Revendications

1. Mémoire matricielle intégrée avec un circuit de contrôle de l'adressage de la matrice (10; 10-1 à 10-4; 30-1 à 30-4) avec des éléments de mémoire qui sont disposés aux intersections des conducteurs de rangées (15; 35a à 35d, 36a à 36c) et des conducteurs de colonnes (19; 19-1 à 19-4; 39-1 à 39-4), l'adressage étant assuré par une adresse à plusieurs bits par l'intermédiaire d'un décodeur qui comprend au moins un décodeur de rangée (12; 42a à 42d) et un décodeur de colonne (14; 44) dont chacun est prévu pour recevoir et décoder une autre partie des bits d'adresse et exciter respectivement un autre conducteur de rangée et ou au moins un conducteur de colonne par l'intermédiaire de sélecteurs (16; 16-1 à 16-4; 46-1 à 46-4) et relier au moins une connexion de sortie (18; 18-1 à 18-4; 38-1 à 38-4),
caractérisée en ce qu'un bus de test (21; 51, 53) est prévu avec plusieurs conducteurs et chaque conducteur peut être couplé avec au moins un conducteur de rangée (15; 35a à 35d, 36a à 36d) sur le côté opposé au décodeur de rangée (12; 42a à 42d) de la matrice (10; 10-1 à 10-4; 30-1 à 30-4) et avec au moins un conducteur de colonne (19; 19-1 à 19-4; 39-1 à 39-4) sur le côté de la matrice opposée aux sélecteurs (16; 16-1 à 16-4; 46-1 à 46-4) pour relier respectivement un nombre de conducteurs de rangées avec au moins un nombre de conducteurs de colonnes.

2. Mémoire matricielle selon la revendication 1,
caractérisée en ce que chaque conducteur du bus de test (21; 51, 53) est couplé par l'intermédiaire de premiers commutateurs de test (22; 52a à 52d, 54a à 54d) avec au moins un autre conducteur de rangée (15; 35a à 35d, 36a à 36d) et/ou par l'intermédiaire de deuxièmes commutateurs de test (20; 20-1 à 20-4; 50-1 à 50-4) avec au moins un autre conducteur de colonne (19; 19-1 à 19-4; 39-1 à 39-4) et que les premiers commutateurs de test et/ou les deuxièmes commutateurs de test peuvent être excités ensemble, du moins en groupe, par un signal de commande de test.

3. Mémoire matricielle selon la revendication 2 avec plusieurs matrices (10-1 à 10-4; 30-1 à 30-4) dont les conducteurs de rangées (15; 35a à 35d, 36a à 36d), du moins de quelques-unes des matrices (10-1 à 10-4; 30-1 à 30-4), à partir du décodeur de rangée (12; 42a à 42d), sont montés en série et l'un des conducteurs de colonnes (19-1 à 19-4, 39-1 à 39-4) dans chaque matrice peut être sélectionné simultanément par le décodeur de colonne (14; 44) et peut être monté à une connexion de sortie propre (18-1 à 18-4; 38-1 à 38-4) pour chaque matrice,
caractérisée en ce que les conducteurs du bus de test (21; 51, 53) peuvent être couplés avec les conducteurs de colonnes (19-1 à 19-4, 39-1 à 39-4) de toutes les matrices (10-1 à 10-4, 30-1 à 30-4), l'affectation des différents conducteurs du bus de test aux conducteurs de colonnes étant différente pour au moins quelques matrices.

4. Mémoire matricielle selon la revendication 3, chaque matrice (30-1 à 30-4) comprenant le même nombre de sous-matrices (31a à 31d, ..., 34a à 34b) et les conducteurs de rangées (35a, 36a à 35d, 36d) des sous-matrices étant excités parallèlement et un décodeur de bloc (48a, 48c) étant prévu pour n'activer respectivement qu'une sous-matrice dans chaque matrice,
caractérisée en ce que les conducteurs de rangées (35a, 36a à 35d, 36d) des sous-matrices (31a à 34a, ..., 31d à 34d) peuvent être couplés avec les conducteurs du bus de test (51, 53) par l'intermédiaire de troisièmes commutateurs de test (56a à 56d, 58a à 58d) commandés par le décodeur de bloc (48a, 48c), l'affectation des conducteurs de rangées respectifs aux conducteurs du bus de test différant d'au moins quelques sous-matrices.

5. Mémoire matricielle selon la revendication 4,
caractérisée en ce que les troisièmes commutateurs de test (56a à 56d, 58a à 58d) sont disposés en série avec les premiers commutateurs de test (52a à 52d,54a à 54d).

6. Mémoire matricielle selon l'une des revendications 3, 4 ou 5, les matrices (10-1 à 10-4; 30-1 à 30-4) étant réparties en deux groupes de même grandeur et le décodeur de rangée (42a à 42d) étant disposé entre les deux groupes et excitant parallèlement les conducteurs de rangées (35a à 35d et 36a à 36d) pour les deux groupes,
caractérisée en ce qu'un bus de test (51, 53) est respectivement prévu sur les faces opposées au décodeur de rangée (42a à 42d) des deux groupes de matrices (30-1, 30-2 et 30-3, 30-4), chaque bus de test pouvant au moins être couplé aux conducteurs de colonnes (39-1 à 39-4) d'une partie des matrices (30-1, 30-2 et 30-3, 30-4).
